# EUROPÄISCHE PATENTANMELDUNG

(11) **EP 1 109 222 A1**
(43) Veröffentlichungstag der Anmeldung: **20.06.2001**
(21) Anmeldenummer: 00125688.2
(22) Anmeldetag: 23.11.2000
(51) Int. Cl.: H01L 27/02, G11C 5/14

(54) **Anordnung zum Trimmen von Referenzspannungen in Halbleiterchips, insbesondere Halbleiterspeichern**

(30) Priorität: 14.12.1999 DE 19960244
(71) Anmelder: Infineon Technologies AG, 81669 München (DE)
(72) Erfinder: Ohlhoff, Carsten, 81737 München (DE)
(74) Vertreter: MÜLLER & HOFFMANN Patentanwälte

(57) **Zusammenfassung**

Die Erfindung betrifft eine Anordnung zum Trimmen von Referenzspannungen in Halbleiterchips, bei der eine Testlogik (2) mittels einer Trimmschaltung (4) das Trimmen auf Chipebene durch Vergleich einer extern zugeführten Vergleichsspannung (Vvgl) mit einer von der Trimmschaltung (4) veränderten Referenzspannung (Vref_trim) vornimmt.

## Beschreibung

Die vorliegende Erfindung betrifft eine Anordnung zum Trimmen von Referenzspannungen, die in Halbleiterchips erzeugt sind, welche in einem Halbleiterwafer vorgesehen sind, bei der die Referenzspannungen in einem Testprogramm mit einer extern zugeführten Spannung verglichen und mittels einer Korrekturinformation an die externe Spannung als jeweiligen, für sämtlich Halbleiterchips des Halbleiterwafers gleichen Zielwert der Referenzspannungen angeglichen werden. Eine solche Anordnung ist aus der DE 196 41 857 A1 bekannt.

Halbleiterchips bzw. in Halbleiterchips realisierte integrierte Schaltungen benötigen oft geregelte interne Spannungen, damit sie in ihrer Funktion gegenüber Schwankungen in externen Spannungsversorgungen unempfindlich sind. Die Spannungsregulierung erfolgt dabei bevorzugt mit Hilfe einer intern erzeugten und eine besonders niedrige Temperaturabhängigkeit aufweisenden Referenzspannung.

Infolge der bei der Herstellung von Halbleiterchips praktisch immer vorhandenen Parameterschwankungen, wie beispielsweise Diffusionstemperaturen usw., weisen die Referenzspannungswerte für fertig hergestellte Halbleiterchips eine gewisse und nicht zu vernachlässigende Verteilungsbreite auf. Um nun diese Verteilungsbreite möglichst gering zu halten und um für alle Halbleiterchips eine identische Referenzspannung bzw. identische interne Spannungen zu erzeugen, wird die Referenzspannung in einem Testprogramm, mit dem auch die Funktionalität des Halbleiterchips überprüft wird, getrimmt. Um dies zu ermöglichen, wird der Halbleiterchip mit einer entsprechenden Logik versehen, die eine in Laser-Fuses abspeicherbare Korrekturinformation in eine Spannungsänderung umwandelt.

Halbleiterchips und insbesondere Halbleiterspeicher werden derzeit bevorzugt bereits auf Waferebene intensiv getestet, was kostengünstiger als ein Testen auf Chipebene ist. Das Trimmen erfolgt dabei in der Weise, daß die zu trimmende Spannung gemessen und sodann auf der Grundlage des so erhaltenen Meßwertes eine chipspezifische Korrekturadresse berechnet wird. Gegebenenfalls kann der auf diese Weise mittels der Korrekturadresse erhaltene Korrekturwert anschlie-βend über spezielle Testmodes in den Halbleiterchip einprogrammiert werden, um sodann in einem weiteren Trimmschritt den so erhaltenen Wert noch einmal zu korrigieren.

Ein derartiges Trimmen ist aber relativ zeitaufwendig und muß für jeden Halbleiterchip einzeln durchgeführt werden.

Weiterhin ist auch noch folgendes zu bedenken:

Während Funktionaltests für viele Halbleiterchips parallel durchgeführt werden können, kann beim Trimmen durch eine Erhöhung der Parallelität die Testzeit nicht verringert werden. Bei einer immer größer werdenden Parallelität bei Wafertests führt dies zu einem immer größer werdenden Anteil an der Testzeit, der für das Trimmen benötigt wird. Insbesondere kann bei zukünftig angestrebten Full-Wafer-Tests, also bei parallelen Tests eines ganzen Wafers, eine kostensteigernde Testzeitverlängerung nicht verhindert werden.

Derzeit erfolgt das Trimmen von Halbleiterchips seriell. Dabei kann beispielsweise ein übliches Prüfprogramm parallel für n Halbleiterchips ablaufen, wobei n beispielsweise den Wert 16 hat. Diese Halbleiterchips werden parallel mit Hilfe von speziellen Nadelkarten kontaktiert. Für einen anschlie-βenden Trimmschritt werden sodann beispielsweise jeweils (n - 1) Halbleiterchips ausmaskiert und für den jeweils verbleibenden Halbleiterchip eine Korrekturadresse ermittelt.

Das Trimmen erfolgt auf diese Weise seriell für alle n Halbleiterchips, was einen beträchtlichen Zeitaufwand erfordert.

Es ist daher Aufgabe der vorliegenden Erfindung, eine Anordnung zu schaffen, mit der ein Trimmen von Referenzspannungen in Halbleiterchips rasch und kostengünstig durchgeführt werden kann.

Diese Aufgabe wird bei einer Anordnung der eingangs genannten Art erfindungsgemäß durch eine auf jedem Halbleiterchip vorgesehene Testlogik gelöst, die einem in dem Halbleiterchip vorgesehenen Spannungskomparator nachgeschaltet ist, der die extern zugeführte Spannung mit einer von einer Trimmschaltung gelieferten und von dieser veränderten Referenzspannung vergleicht.

Mit der erfindungsgemäßen Anordnung kann so das Trimmen der Referenzspannungen von einem Testgerät direkt auf den zu trimmenden Halbleiterchip verlagert werden, was mit beträchtlichen Vorteilen verbunden ist:

Zunächst werden die für das Trimmen erforderliche Zeit und damit auch die Testkosten erheblich reduziert, wobei die Einsparung um so größer ist, je mehr Halbleiterchips mit der erfindungsgemäßen Anordnung parallel getestet werden. Da kein externes Testgerät mehr benötigt wird, besteht auch kein Bedarf an Gleichstrom-Spannungsmeßeinheiten, was insbesondere bei hoher Parallelität von Bedeutung ist. Bei manchen Testgeräten ist nämlich die maximal vorhandene Anzahl an solchen Spannungsmeßeinheiten niedriger als die Anzahl der parallel zu testenden Halbleiterchips. Das von der Anordnung durchzuführende Testprogramm ist vereinfacht, da dieses alle Halbleiterchips parallel zu testen vermag.

Hochintegrierte Schaltungen in Halbleiterchips sollten bevorzugt einem Selbsttestprogramm unterworfen werden, bei dem nur noch eine begrenzte Anzahl von externen Steuersignalen zur Kontrolle eines Testablaufes notwendig und vorhanden ist. Bei der erfindungsgemäßen Anordnung müssen anders als bei einem iterativen Trimmen keine Korrekturadressen an einen Halbleiterchip übergeben werden. Damit ist ein Selbst-Trimmen aber eine notwendige Ergänzung für jede weitgehende Selbsttest-Strategie, bei der die Schnittstelle zum Halbleiterchip so stark reduziert ist, daß eine Übergabe von Korrekturadressen nicht mehr möglich ist.

Die erfindungsgemäße Anordnung benötigt von einem externen Testgerät nur noch die Bereitstellung einer Vergleichsspannung, so daß eine Leitung bzw. ein Kontakt zu einem Testkopf dieses Testgerätes ausreichend ist. Dies stellt eine wesentliche Vereinfachung gegenüber herkömmlichen Anordnungen dar, bei denen für die Spannungsmessung eine separate Leitung zu jedem der n parallel kontaktierten Halbleiterchips erforderlich ist.

Wesentlich an der vorliegenden Erfindung ist also die Durchführung des Trimmens mittels einer speziellen Anordnung auf dem zu trimmenden Halbleiterchip. Dabei wird eine statische Vergleichsspannung auf jeden Halbleiterchip durch eine externe Spannungsquelle, die in einem externen Testgerät vorhanden ist, eingeprägt. Auf dem Halbleiterchip erfolgt durch die erfindungsgemäße Anordnung sodann ein automatischer Abgleich der trimmbaren internen Spannungen auf die extern eingeprägte statische Vergleichsspannung. Für das Trimmen benötigte Information, die sogenannte Trimminformation, also insbesondere Korrekturadressen, wird beispielsweise mit Hilfe von elektrischen Fuses oder Anti-Fuses auf den einzelnen Halbleiterchips gespeichert. Ebenso ist es aber auch möglich, die Trimminformation an ein Testgerät zu übermitteln und anschließend Laserfuses oder andere Fuses zu schießen.

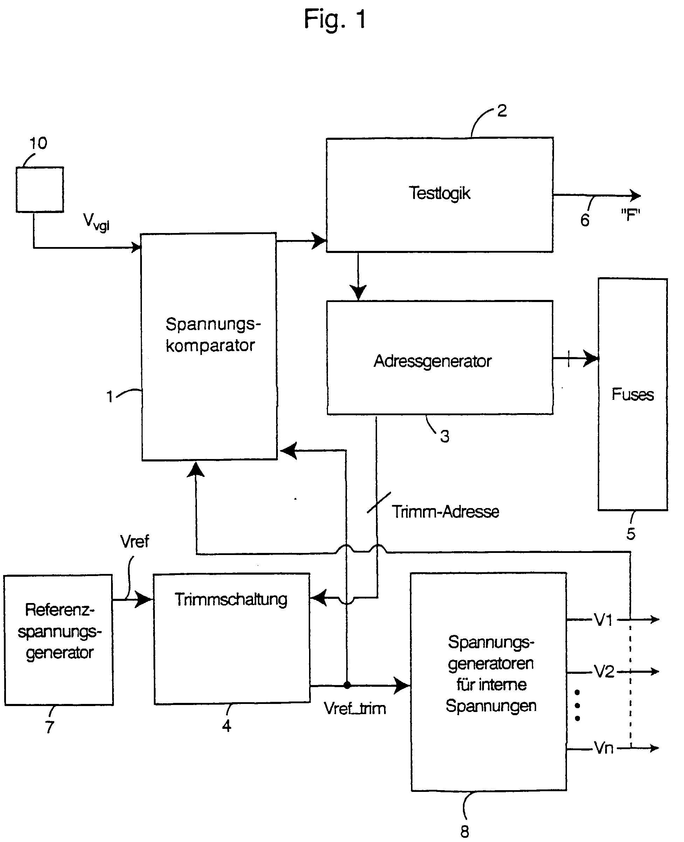

Nachfolgend wird die Erfindung anhand der Zeichnung näher erläutert, in deren einziger Figur ein Blockschaltbild der erfindungsgemäßen Anordnung dargestellt ist.

Spannungsregulierte Halbleiterchips verfügen im allgemeinen über eine zentrale, temperaturstabile, interne Referenzspannung Vref, die von einem Referenzspannungsgenerator geliefert wird. Auf einem ungetrimmten Halbleiterchip streut diese Referenzspannung Vref aus produktionstechnischen Gründen zunächst um einen vom Design des Halbleiterchips vorgegebenen Zielwert.

Die einzige Figur der Zeichnung zeigt nun eine erfindungsgemäße Anordnung in einem Halbleiterchip mit einer Referenzspannungsgenerator 7, der die konstante Referenzspannung Vref abgibt, aus welcher eine Trimmschaltung 4 eine veränderte Referenzspannung Vref_trim erzeugt.

Um nun ein Trimmen der Referenzspannung Vref auf dem Halbleiterchip selbst durchführen zu können, wird bei der erfindungsgemäßen Anordnung eine externe Vergleichsspannung Vvgl über beispielsweise eine Sondennadel, die ein Pad bzw. Kontaktkissen 10 auf dem Halbleiterchip kontaktiert und die über die notwendige Genauigkeit verfügt, auf den Halbleiterchip eingeprägt. Die externe Vergleichsspannung Vvgl wird von dem Pad 10 zu einem Spannungskomparator 1 geliefert, der die Vergleichsspannung Vvgl mit der veränderten Referenzspannung Vref_trim oder einer geeigneten, aus dieser veränderten Referenzspannung Vref_trim in Spannungsgeneratoren 8 erzeugten Spannung (V1, V2, ..., Vn) vergleicht.

Abhängig von dem Vergleichsergebnis in dem Spannungskomparator 1 steuern eine Testlogik 2 und ein Adreßgenerator 3 eine Trimmschaltung 4, die beispielsweise aus einem Widerstandsteiler besteht, bei dem Widerstände zu- und weggeschaltet werden können, an, so daß diese Trimmschaltung 4 aus der konstanten Referenzspannung Vref eine veränderte Referenzspannung Vref_trim liefert. Dieses Trimmen erfolgt beispielsweise in der Weise, daß der Adreßgenerator 3 nacheinander alle möglichen Adressen an die Trimmschaltung 4 anlegt, so daß die veränderte Referenzspannung Vref_trim in bestimmten Spannungsintervallen durchgestimmt wird.

Diese veränderte Referenzspannung Vref_trim wird sodann erneut mit der externen Vergleichsspannung Vvgl im Spannungskomparator 1 verglichen. Das Ergebnis dieses Vergleichs wird der Testlogik 2 übermittelt.

Ergibt der Vergleich im Spannungskomparator 1, der durch die Testlogik 2 ausgewertet wird, daß die veränderte Referenzspannung Vref_trim und die externe Vergleichsspannung Vvgl im Rahmen der durch die Trimmschaltung 4 vorgegebenen Spannungsintervalle nicht übereinstimmen, so legt der Adreßgenerator 3 die nächste Trimmadresse an die Trimmschaltung 4 an. Eine Möglichkeit, diesen Vergleich durchzuführen, besteht in einer Differenzbildung aus der veränderten Referenzspannung Vref_trim und der Vergleichsspannung Vvgl. Wird ein Vorzeichenwechsel der Differenz detektiert, so stimmen die beiden Spannungen mit einem durch die Trimmstufen vorgegebenen Fehler überein. Dieser Vorgang wird so lange wiederholt, bis der in der Testlogik 2 ausgewertete Vergleich im Spannungskomparator 1 die gesuchte Übereinstimmung anzeigt oder alle möglichen Spannungsschritte von der veränderten Referenzspannung Vref_trim, die von der Trimmschaltung abgegeben werden, abgearbeitet sind.

Wird im Spannungskomparator 1 bzw. in der Testlogik 2 eine Übereinstimmung zwischen der externen Vergleichsspannung Vvgl und der veränderten Referenzspannung Vref_trim festgestellt, so wird die betreffende, diese Übereinstimmung liefernde Adresse aus dem Adreßgenerator 3 in elektrischen Fuses 5 abgespeichert.

Alternativ können solche Adressen auch in einem Register abgelegt werden, aus welchem dann das externe Testgerät, das die Vergleichsspannung Vvgl dem Pad 10 aufprägt, die für den Halbleiterchip spezifische Korrekturadresse zu einem späteren Zeitpunkt ausliest. Diese Korrekturadresse kann dann beispielsweise mittels Laser-Fuses wieder auf dem Halbleiterchip abgespeichert werden.

Auf diese Weise kann eine veränderte Referenzspannung Vref_trim, die weitgehend identisch zu einem vorgegebenen Wert ist, erhalten werden, so daß die Spannungsgeneratoren 8 für interne Spannungen daraus die gewünschten geregelten internen Spannungen V1, V2, ..., Vn zu erzeugen vermögen.

Kann eine Übereinstimmung zwischen der externen Vergleichsspannung Vvgl und der von der Trimmschaltung 4 gelieferten veränderten Referenzspannung Vref_trim nicht hergestellt werden, so kann die Testlogik 2 den Halbleiterchip als "Ausfall" F an einem Ausgang 6 markieren, indem ein entsprechendes Signal geliefert und gegebenenfalls zu einer BIST-Logik überführt wird (BIST = Built-in-self-test). Die Information über den Erfolg bzw. Mißerfolg des Trimmens muß also nicht notwendigerweise sofort an ein externes Testgerät übermittelt werden, sondern kann gegebenenfalls auch an eine möglicherweise vorhandene BIST-Logik weitergeleitet werden.

### Bezugszeichenliste

- 1: Spannungskomparator
- 2: Testlogik
- 3: Adreßgenerator
- 4: Trimmschaltung
- 5: Fuses
- 6: Ausgangsanschluß
- 7: Referenzspannungsgenerator
- 8: Spannungsgeneratoren für interne Spannungen
- 10: Pad
- Vvgl: externe Vergleichsspannung
- Vref: Referenzspannung
- Vref_trim: veränderte Referenzspannung
- F: Fehlersignal

## Patentansprüche

1. Anordnung zum Trimmen von Referenzspannungen, die in Halbleiterchips erzeugt sind, welche in einem Halbleiterwafer vorgesehen sind,
bei der die Referenzspannungen (Vref) in einem Testprogramm mit einer extern zugeführten Spannung (Vvgl) verglichen und mittels einer Korrekturinformation an die externe Spannung (Vvgl) als jeweiligen, für sämtliche Halbleiterchips des Halbleiterwafers gleichen Zielwert der Referenzspannungen angeglichen werden,
**gekennzeichnet** durch
eine auf jedem Halbleiterchip vorgesehene Testlogik (2), die einem in dem Halbleiterchip vorgesehenen Spannungskomparator (1) nachgeschaltet ist, der die extern zugeführte Spannung (Vvgl) mit einer von einer Trimmschaltung (4) gelieferten und von dieser veränderten Referenzspannung (Vref_trim) vergleicht.

2. Anordnung nach Anspruch 1,
**dadurch gekennzeichnet,** daß die Testlogik (2) über einen Adreßgenerator (3) mit der Trimmschaltung (4) verbunden ist.

3. Anordnung nach Anspruch 1 oder 2,
**dadurch gekennzeichnet,** daß der Trimmschaltung (4) ein Spannungsgenerator (8) für interne Spannungen (V1, V2, ..., Vn) nachgeschaltet ist.

4. Anordnung nach einem der Ansprüche 1 bis 3,
**dadurch gekennzeichnet,** daß an den Adreßgenerator (3) elektrische Fuses (5) angeschlossen sind, die Adressen der Trimmschaltung (4) bei Übereinstimmung zwischen der veränderten Referenzspannung (Vref_trim) und der extern zugeführten Spannung (Vvgl) speichern.
